# EUROPEAN PATENT SPECIFICATION

(11) **EP 4 163 594 B1**
(45) Date of publication and mention of the grant of the patent: **17.04.2024**
(21) Application number: 21201909.5
(22) Date of filing: 11.10.2021
(51) Int. Cl.: G01C 21/20, G01C 22/00, H04W 4/33, H04W 4/029, G06F 30/13

(54) **WAYFINDING AND GUIDANCE TO ASSETS, DEVICES AND SENSORS IN BUILDINGS**
WEGFINDUNG UND FÜHRUNG ZU ANLAGEN, VORRICHTUNGEN UND SENSOREN IN GEBÄUDEN
ORIENTATION ET GUIDAGE VERS DES RESSOURCES, DES DISPOSITIFS ET DES CAPTEURS DANS DES BÂTIMENTS

(43) Date of publication of application: 12.04.2023
(73) Proprietor: Siemens Schweiz AG, 8047 Zürich (CH)
(72) Inventor: Blatter, Sandro, 9015 St. Gallen (CH); Zechlin, Oliver, 6300 Zug (CH)
(74) Representative: Siemens Patent Attorneys

(56) References cited:
- US-A1- 2015 369 612
- US-A1- 2017 261 334
- US-A1- 2018 328 737
- NEGES MATTHIAS ET AL: "Combining visual natural markers and IMU for improved AR based indoor navigation", ADVANCED ENGINEERING INFORMATICS, ELSEVIER, AMSTERDAM, NL, vol. 31, 11 November 2015 (2015-11-11), pages 18-31, XP029861312, ISSN: 1474-0346, DOI: 10.1016/J.AEI.2015.10.005

## Description

### FIELD OF THE INVENTION

The present invention relates generally to the technical field of building management systems or building automation systems comprising a plurality of building devices, e.g. controllers. In particular the present invention relates to a method and an arrangement for navigating a user to a device located or installed in a building.

### BACKGROUND

To find assets or devices in a building that are hidden behind walls or are otherwise hidden from sight (built into the concrete structure of the building; lowered ceilings etc.) is sometimes onerous for technicians. Technicians usually consult various 2D drawings of questionable age and data quality. Afterwards they try to find the assets or devices via trial and error. The article "Combining visual natural markers and IMU for improved AR based indoor navigation", in Advanced Engineering Informatics 31 (2017), by Matthias Neges et al. , discloses a method for AR based indoor navigation based on a BIM model.

### SUMMARY OF THE INVENTION

The object of the invention is to provide an efficient method and an efficient arrangement for navigating a user to a device or asset located or installed in a building.

A first aspect of the invention is a method for navigating a user to a device located in a building, the method comprising the steps:
providing a mobile communication device (e.g. smartphone, tablet computer) configured to select the device to navigate to by user input, wherein the mobile communication device is connected to an object model (e.g. BIM) representing the devices located in the building;
determining a route from the position of the user to the device to navigate to based on information provided by the object model and/or an Indoor-Positioning-System;
displaying the route to the device to navigate to on the display of the mobile communication device;
tracking the progress of the walking along the determined route by recording measured values of sensors (e.g. step counter or gyrometric sensor) integrated in the mobile communication device;
keeping the user on track and synchronized with the determined route by scanning landmark codes (e.g. QR code) attached in the building and/or by radio and/or audio and/or camera means of the mobile communication device;
synchronizing a pointer representing the user within the object model to the exact same position in the object model the user is currently in the building;
wherein when the user arrives at the device to navigate to, the average step distance of the user, the number of steps the user needed to arrive at the device to navigate to, and the time the user needed to arrive at the device to navigate to is stored in a suitable navigation data memory;
wherein based on the data stored in the navigation data memory future routes for navigating a user to a device located in the building are determined.

A second aspect of the invention is an arrangement for navigating a user to a device located in a building, comprising:
a mobile communication device (smartphone, tablet computer) configured to select the device to navigate to by user input, wherein the mobile communication device is connected to an object model (e.g. BIM) representing the devices located in the building;
a server (e.g. cloud server) comprising access to a memory where the object model is stored, wherein the server is configured to determine a route from the position of the user to the device to navigate to based on information provided by the object model;
wherein the route to the device to navigate to is displayed on the display of the mobile communication device;
wherein the mobile communication device is configured to track the progress of the walking along the determined route by recording measured values of sensors (e.g. step counter or gyrometric sensor) integrated in the mobile communication device;
wherein the mobile communication device is further configured to keep the user on track and synchronized with the determined route by scanning landmark codes (e.g. QR code) attached in the building and/or by radio and/or audio and/or camera means of the mobile communication device;
wherein the server is configured to synchronize a pointer representing the user within the object model to the exact same position in the object model the user is currently in the building;
wherein when the user arrives at the device to navigate to, the average step distance of the user, the number of steps the user needed to arrive at the device to navigate to, and the time the user needed to arrive at the device to navigate to is stored by the server or by the mobile communication device in a suitable navigation data memory;
wherein the server is further configured based on the data stored in the navigation data memory to determine future routes for navigating a user to a device located in the building.

Further aspects of the invention are a computer program product and a computer-readable storage medium comprising instructions which, when the program is executed by a computer, cause the computer to carry out the steps of the inventive method for navigating a user to a device located in a building.

### BRIEF DESCRIPTION OF THE DRAWINGS

The above-mentioned and other concepts of the present invention will now be addressed with reference to the drawings of the preferred embodiments of the present invention. The shown embodiments are intended to illustrate, but not to limit the invention. The drawings contain the following figures, in which like numbers refer to like parts throughout the description and drawings and wherein:
- FIG 1: illustrates an exemplary flowchart of method for navigating a user to a device located in a building,
- FIG 2: illustrates an exemplary arrangement for navigating a user to a device located in a building,
- FIG 3: illustrates a first exemplary image of a display to navigate a user to a device located in a building, and
- FIG 4: illustrates a second exemplary image of a display to navigate a user to a device located in a building.

### DETAILED DESCRIPTION

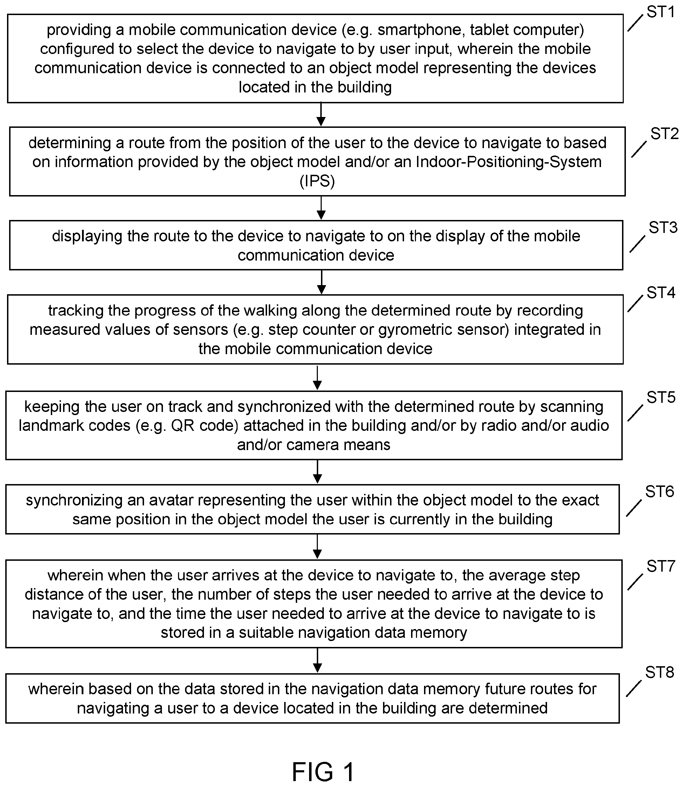

Figure 1 illustrates an exemplary flowchart of method for navigating a user to a device located in a building. The method comprising the steps:
(ST1) providing a mobile communication device (e.g. smartphone, tablet computer) configured to select the device to navigate to by user input, wherein the mobile communication device is connected to an object model (OM) representing the devices located in the building;
(ST2) determining a route from the position of the user to the device to navigate to based on information provided by the object model (OM) and/or an Indoor-Positioning-System (IPS) ;
(ST3) displaying the route to the device to navigate to on the display of the mobile communication device;
(ST4) tracking the progress of the walking along the determined route by recording measured values of sensors (e.g. step counter or gyrometric sensor) integrated in the mobile communication device;
(ST5) keeping the user on track and synchronized with the determined route by scanning landmark codes (e.g. QR code) attached in the building and/or by radio and/or audio and/or camera means of the mobile communication device (MG);
(ST6) synchronizing a pointer (e.g. a graphical indicator, e.g. an arrow or an point) representing the user within the object model (OM) to the exact same position in the object model (OM) the user is currently in the building;
(ST7) wherein when the user arrives at the device to navigate to, the average step distance (ASD) of the user (P), the number of steps (NS) the user (P) needed to arrive at the device (Dev) to navigate to, and the time (T) the user needed to arrive at the device (Dev) to navigate to is stored in a suitable navigation data memory (NDM);
(ST8) wherein based on the data stored in the navigation data memory future routes for navigating a user to a device located in the building are determined.

The method can be performed by using commercial off the shelf (COTS) devices which are configured and equipped with suitable HW means and software programs. The mobile communication device can be a smartphone or a tablet computer. Advantageously tracking the route is supported by an Indoor-Positioning-System (IBeacons, WLAN, etc). Advantageously scanning of landmark codes is performed by a QR code reader of the mobile communication device. The QR code reader can be installed on the mobile communication device by a suitable App (e.g. by download from an App-Store). For example, IFC notation (industry foundation class) can be used as object model notation. The method can be realized by using a cloud infrastructure, comprising a cloud server with access to the object model. The cloud server comprises means for processing, communicating, and storing.

The object model can be stored locally on the mobile communication device, partly or completely).

The object model can also be stored on the server and streamed and/or mirrored and/or loaded from the server to the mobile communication device.

According to Wikipedia an avatar is a graphical representation of a user or the user's character or persona. It may take either a two-dimensional form as an icon in Internet forums and other online communities or a three-dimensional form, as in games or virtual worlds.

Advantageously displaying the route comprises the illustration of the pointer the route. The pointer is a graphical representation of the user on the display of the mobile communication device. The pointer can be for instance, an arrow or a point or an avatar.

Advantageously the navigation data memory is part of the object model.

Advantageously the object model is a building information model (BIM) or a UNITY-based rendered model (e.g. a 3D-model). Advantageously the object model is represented in IFC notation.

The method can be realized in an online-mode or in an offline-mode. In the online-mode the mobile communication device is connected permanently with a server (e.g. cloud server) providing the object model (e.g. BIM Model). In the offline-mode the object model is stored locally on the mobile communication device. Advantageously the user can switch between online-mode and offline-mode. Advantageously during online-mode an object model stored locally on the mobile communication device can be updated and/or synchronized according to an object model stored in a server (e.g. cloud server). Advantageously information regarding the device (e.g. asset to be navigated to) is provided and displayed to a user on the mobile communication device. Advantageously the user can retrieve information about the device and/or communicate and/or interact directly with the device (e.g. an IoT device, connected to the Internet). Optionally this interaction is then also stored directly in the asset, sent to a server, and/or first kept locally and later optionally "synchronized". Furthermore, optimized service technician are able to be routed to the device (asset). Advantageously several route variants are provided which can be selected by the user: fastest route to the device (asset) to be navigated to and/or optimal route (taking into account expected on-site complexity as far as service is concerned) and/or whatever-it-takes route.

Further aspects of the invention are a computer program product and a computer-readable storage medium comprising instructions which, when the program is executed by a computer, cause the computer to carry out the steps of the inventive method for navigating a user to a device located in a building.

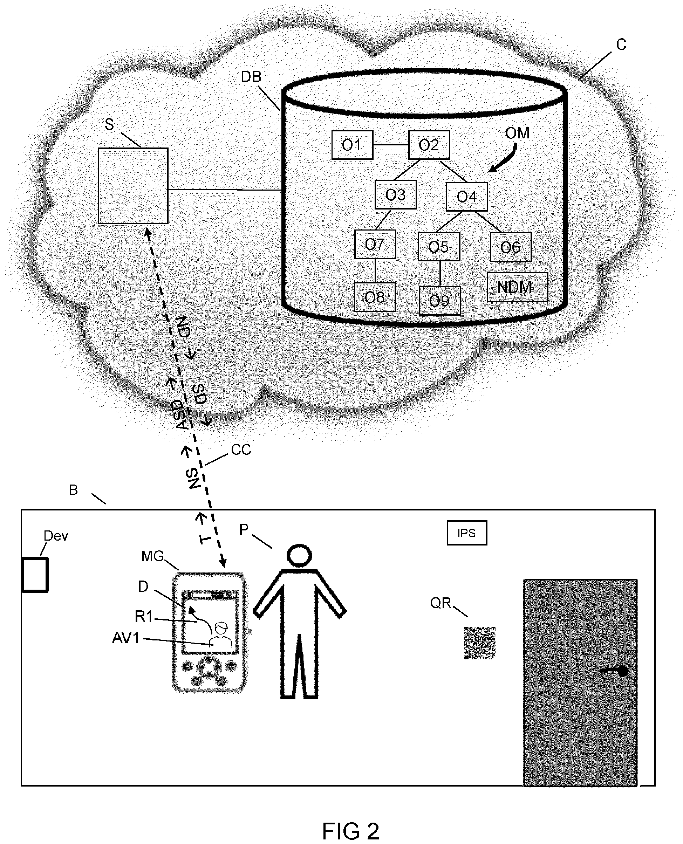

Figure 2 illustrates an exemplary arrangement for navigating a user P to a device Dev located in a building B. The exemplary arrangement comprises:
a mobile communication device MG (e.g. smartphone, tablet computer) configured to select the device Dev to navigate to by user input, wherein the mobile communication device MG is connected to an object model OM representing the devices Dev located in the building B;
a server S comprising access to a memory DB where the object model OM is stored, wherein the server S is configured to determine a route R1 from the position of the user P to the device Dev to navigate to based on information provided by the object model OM;
wherein the route R1 to the device Dev to navigate to is displayed on the display D of the mobile communication device MG;
wherein the mobile communication device MG is configured to track the progress of the walking along the determined route R1 by recording measured values of sensors (e.g. step counter or gyrometric sensor) integrated in the mobile communication device MG;
wherein the mobile communication device MG is further configured to keep the user P on track and synchronized with the determined route R1 by scanning landmark codes QR (e.g. QR code, bar code) attached in the building B and/or by radio and/or audio and/or camera means of the mobile communication device MG;
wherein the server S is configured to synchronize a pointer AV1 - AV3 representing the user P within the object model OM to the exact same position in the object model OM the user P is currently in the building B;
wherein when the user P arrives at the device Dev to navigate to, the average step distance of the user P, the number of steps the user needed to arrive at the device Dev to navigate to, and the time the user needed to arrive at the device Dev to navigate to is stored by the server S or by the mobile communication device MG in a suitable navigation data memory NDM;
wherein the server S is further configured based on the data stored in the navigation data memory NDM to determine future routes R1 - R3 for navigating a user P to a device Dev located in the building B. The device Dev to navigate to can be a controller installed in the building B. The device Dev to navigate to can also be an asset (e.g. technical equipment or a machine) located in the building B. The mobile communication device MG can be a suitable configured smartphone or tablet computer. The mobile communication device MG comprises suitable sensors (e.g. step counter or gyrometric sensor). The sensors can be integrated in the mobile communication device MG. Sensor functionality can also be installed on the mobile communication device MG by download of an App providing sensor functionality.

Advantageously for determining the position of the user P in the building an Indoor-Positioning-System IPS (e.g. IBeacons, BLE, WLAN) is used. The mobile communication device MG is configured to communicate with the Indoor-Positioning-System IPS to determine the position of the mobile communication device MG.

The mobile communication device MG is configured to read or scan, and process landmark codes QR (e.g. QR code, bar code) located in the building B. Advantageously the mobile communication device MG comprises a suitable QR-Code Reader (e.g. an App).

Advantageously the server S, the memory DB, and the navigation data memory NDM are implemented in a cloud infrastructure C. The cloud infrastructure C is providing suitable processing means, storing means, and communication means.

The server S is a suitable computer (e.g. desktop computer, workstation, laptop) comprising suitable processing means (Hardware and Software), storing means (e.g. ROM, RAM, Flash memories), and communication means (e.g. Internet connection).

The memory DB where the object model OM is stored can be suitable database (relational database, In-Memory database, etc.). The object model OM represents the devices and/or assets of the building B in a suitable data model or object model OM. The data model or object model OM is representing and/or mapping the devices Dev and/or assets of the building B in a suitable notation (e.g. IFC notation, Industry Foundation Class). The devices Dev and/or assets of the building B are represented in the data model or object model OM by respective objects O1 - O9.

Advantageously the data model or object model OM comprises attributes and relationships of the objects O1 - O9. Advantageously the data model or object model OM is a building information model (BIM model). A BIM model is a building model that can be used by all parties involved in a building project (architects, engineers, fire protection specialists, building authorities, HVAC engineers, facility management specialists) during the design, construction and operation phases of a building. In the BIM model (building model), all relevant building data is digitally captured, combined and networked. The BIM model is thus a virtual model of the building and the trades installed in the building. An appropriately maintained BIM model ensures that the trades installed in the building and their relationships are up to date. It is advantageous for a BIM model to be based on the standardized "Industry Foundation Classes" (IFC). It is advantageous for the BIM model to include, among other things, the installation location of the trades located in a building (e.g. HVAC systems for heating, ventilation or cooling).

In the navigation data memory NDM navigation data from and/or for the respective routes R1 are collected and stored. The navigation data memory NDM is storing for instance the following data: the average step distance of the user P, the number of steps the user P needed to arrive at the device Dev to navigate to, and the time the user P needed to arrive at the device Dev to navigate to. These data are used for navigation and synchronization a user on future routes. This can be accomplished by means of artificial intelligence (AI), e.g. neuronal networks, machine learning algorithms, deep learning algorithms. The navigation data memory NDM can be an object and/or a part of the object model OM. The navigation data memory NDM can be a part of the database DB. The navigation data memory NDM can also be implemented in a separate database.

The user P can be for instance, a facility manager, a service or maintenance worker, or a commissioner.

By using suitable communication connections CC (e.g. WLAN, radio, Internet) the mobile communication device MG of the user P communicates with the server S. The mobile communication device MG is providing the following data to the server S: the Average Step Distance ASD, the time T (actual time and/or time consumed since starting point), Number of Steps (since starting point) NS. These data are stored in the navigation data memory NDM for future route navigations. These data are processed by the server S to provide for the current route synchronization data SD and navigation data ND. Advantageously navigation data ND are also provided by the Indoor-Positioning-System IPS. Advantageously the server S, the Indoor-Positioning-System IPS, and the mobile communication device MG are configured to collaborate to determine and/or provide the respective synchronization data SD and navigation data ND.

The user P that needs to find a device Dev (e.g. a sensor or valve or controller) uses an app or other computer-aided solution to calculate the quickest / safest / most-efficient /etc. way to reach the target Dev. In order to achieve this, the information is being calculated with the help of an accurate object model OM (e.g. 3D BIM model, Building Information Model). Afterwards the tracking can begin. The software / algorithm (invention) utilizes one or multiple sensors within a portable communication device MG (e.g. smartphone, tablet, ...), for example a step counter or gyrometric sensor. With that information at hand, the invention tracks the progress along the calculated and chosen route R1. During all that time the user P can visibly track the position of his/her pointer (e.g. avatar AV1) within the app (3D representation) and compare it to the real time and real-life view of his current position.

To keep the user P on track and synchronized with the navigation route R1 inside the object model OM (e.g. BIM model), the invention allows him to scan various QR codes QR or receive information via other means, such as e.g. radio, audio or camera. These codes will synchronize his/her avatar AV1 inside the object model OM (e.g. BIM model) to the exact same position that he is currently in. The invention can also make use of integrated sensors, such as a light-detection-sensor, of a smart device MG, to detect whether the user P has been near to a lamp or a bright light source. This information will be at or near-real-time compared to the object model OM (e.g. BIM model). Inside the object model OM there will be a look up for a corresponding light source and the pointer (e.g. avatar AV1) will be calibrated according to that information. Basically, the person/user P becomes the Avatar AV1 within the object model OM. The Avatar's AV1 position will be determined by the current location of the person/user P using the app. The "playing field", the Avatar's world, is a representation, a real model of the real building B the person/user P is moving in.

After the arrival of the user P at the target Dev location, the invention will calculate the average step distance ASD and time T needed. This information can be used to compute a better approximation of step length and other movement information (stride, slow downs etc.) in future navigation calculations. Henceforth, the tracking of the or a similar generic user P and its corresponding synchronization with the pinter (e.g. avatar AV1) inside the object model OM will be more accurate.

A person P that must look in a building B for a certain device Dev will find that device Dev a lot faster than previous. So, saving precious time for actual fixing the device. Especially when the device Dev is hidden for example in a lower ceiling, the person that need to find a device there, must demount various overhead panels to find the wished device. With this invention there is no need for searching and hoping a device will be there. The person P will be shown the fastest way R1 to it and the navigation will be synchronized with the latest data of the object model OM.

Advantageously the mobile communication device MG is configured to illustrate the pointer AV1 (e.g. avatar AV1) on the route R1. The pointer AV1 can be illustrated for instance, in form of an arrow, or as a point, or as an avatar AV1.

Advantageously the navigation data memory NDM is part of the object model OM.

Advantageously the object model OM is a building information model (BIM) or a UNITY-based rendered model.

Advantageously the server S is part of a cloud infrastructure C or implemented in a cloud infrastructure C.

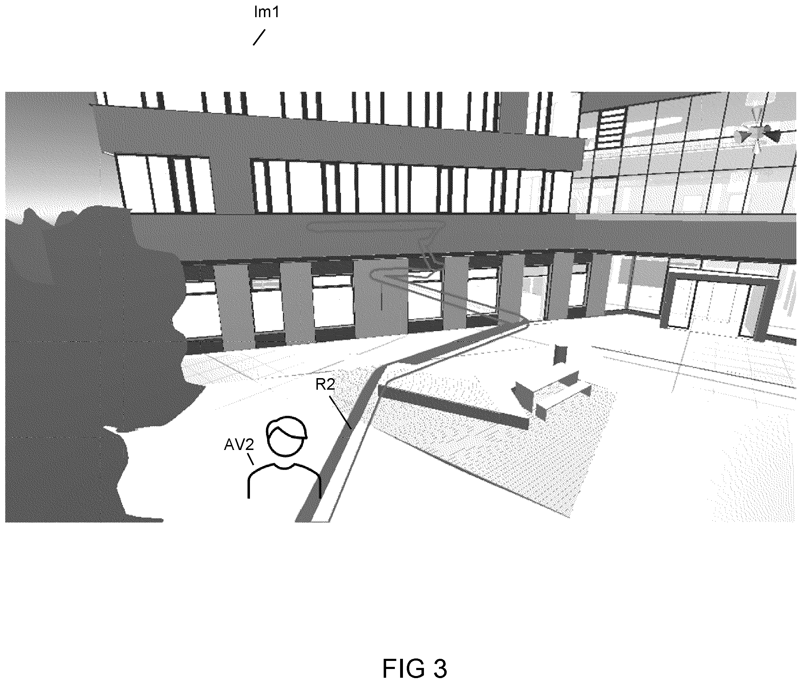

Figure 3 illustrates a first exemplary image Im1 of a display of a mobile communication device to navigate a user to a device or object located in a building. Figure 3 shows a fully calculated way (route R2) in a schematic building to the object (e.g. device or asset) to be navigated to, and an avatar AV2 representing the user.

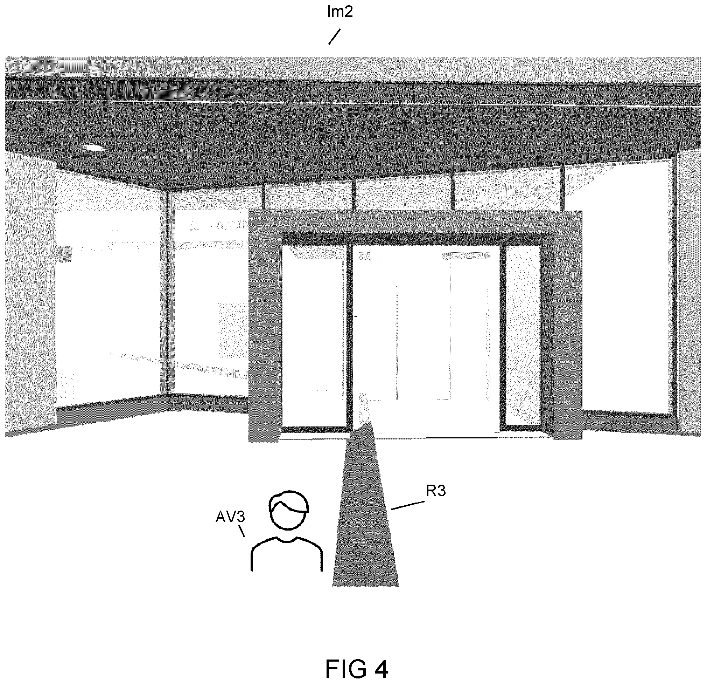

Figure 4 illustrates a second exemplary image Im2 of a display of a mobile communication device to navigate a user to a device or object located in a building. Figure 4 shows a view during navigation to the object (e.g. device or asset) to be navigated to on the respective route R3, and an avatar AV3 representing the user.

### Reference Signs

- OM: Object Model
- O1 - O9: Object
- Dev: Device
- Im1, IM2: Image
- D: Display
- B: Building
- QR: QR Code
- R1 - R3: Route
- AV1 - AV3: Avatar
- S: Server
- DB: Database
- C: Cloud
- P: User
- IPS: Indoor-Positioning System
- CC: Communication Connection
- MG: Mobile Communication Device
- T: Time
- NS: Number of Steps
- ASD: Average Step Distance
- ND: Navigation Data
- SD: Synchronization Data
- NDM: Navigation Data Memory
- ST1 - ST8: Step

## Claims

1. A method for navigating a user (P) to a device (Dev) located in a building (B), the method comprising the steps:
(ST1) providing a mobile communication device (MG) configured to select the device (Dev) to navigate to by user input, wherein the mobile communication device (MG) is connected to an object model (OM) representing the devices (Dev) located in the building (B);
(ST2) determining a route (R1 - R3) from the position of the user (P) to the device (Dev) to navigate to based on information provided by the object model (OM) and/or an Indoor-Positioning-System (IPS);
(ST3) displaying the route (R1 - R3) to the device (Dev) to navigate to on the display (D) of the mobile communication device (MG);
(ST4) tracking the progress of the walking along the determined route (R1 - R3) by recording measured values of sensors integrated in the mobile communication device (MG);
(ST5) keeping the user (P) on track and synchronized with the determined route (R1 - R3) by scanning landmark codes (QR) attached in the building (B) and/or by radio and/or audio and/or camera means of the mobile communication device (MG);
(ST6) synchronizing a pointer (AV1 - AV3) representing the user (P) within the object model (OM) to the exact same position in the object model (OM) the user (P) is currently in the building (B);
(ST7) **characterized in that**, when the user (P) arrives at the device (Dev) to navigate to, the average step distance (ASD) of the user (P), the number of steps (NS) the user (P) needed to arrive at the device (Dev) to navigate to, and the time (T) the user needed to arrive at the device (Dev) to navigate to is stored in a suitable navigation data memory (NDM);
(ST8) wherein based on the data stored in the navigation data memory (NDM) future routes for navigating a user (P) to a device (Dev) located in the building (B) are determined.

2. The method according to claim 1, wherein displaying the route (R1 - R3) comprises the illustration of the pointer (AV1 - AV3), especially as an avatar (AV1 - AV3), on the route.

3. The method according claim 1 or claim 2, wherein the navigation data memory is part of the object model (OM).

4. The method according to one of the preceding claims, wherein the object model (OM) is a building information model (BIM) or a 3D-model.

5. An arrangement for navigating a user (P) to a device (Dev) located in a building (B), comprising:
a mobile communication device (MG) configured to select the device (Dev) to navigate to by user input, wherein the mobile communication device (MG) is connected to an object model (OM) representing the devices (Dev) located in the building (B) ;
a server (S) comprising access to a memory (DB) where the object model (OM) is stored, wherein the server (S) is configured to determine a route (R1 - R3) from the position of the user (P) to the device (Dev) to navigate to based on information provided by the object model (OM);
wherein the route (R1 - R3) to the device (Dev) to navigate to is displayed on the display (D) of the mobile communication device (MG);
wherein the mobile communication device (MG) is configured to track the progress of the walking along the determined route (R1 - R3) by recording measured values of sensors integrated in the mobile communication device (MG);
wherein the mobile communication device (MG) is further configured to keep the user (P) on track and synchronized with the determined route (R1 - R3) by scanning landmark codes (QR) attached in the building (B) and/or by radio and/or audio and/or camera means of the mobile communication device (MG);
wherein the server (S) is configured to synchronize a pointer (AV1 - AV3) representing the user (P) within the object model (OM) to the exact same position in the object model (OM) the user is currently in the building (B);
2. **characterized in that**, when the user (P) arrives at the device (Dev) to navigate to, the average step distance (ASD) of the user (P), the number of steps the user (P) needed to arrive at the device (Dev) to navigate to, and the time (T) the user needed to arrive at the device (Dev) to navigate to is stored by the server (S) or by the mobile communication device (MG) in a suitable navigation data memory (NDM);
wherein the server (S) is further configured based on the data stored in the navigation data memory (NDM) to determine future routes (R1 - R3) for navigating a user (P) to a device (Dev) located in the building (B).

6. The arrangement according to claim 5, wherein the mobile communication device (MG) is configured to illustrate the pointer (AV1 - AV3), especially as an avatar (AV1 - AV3), on the route (R1 - R3).

7. The arrangement according claim 5 or claim 6, wherein the navigation data memory (NDM) is part of the object model (OM).

8. The arrangement according to one of the preceding claims 5 to 7, wherein the object model (OM) is a building information model (BIM) or a 3D-model.

9. The arrangement according to one of the preceding claims 5 to 8, wherein the server (S) is part of a cloud infrastructure (C) .

## Patentansprüche

1. Verfahren für das Navigieren eines Benutzers (P) zu einem Gerät (Dev), das sich in einem Gebäude (B) befindet, mit folgenden Schritten:
(ST1) Bereitstellen eines Mobilkommunikationsgeräts (MG), das so konfiguriert ist, dass es per Benutzereingabe das Gerät (Dev) auswählt, zu dem hin navigiert werden soll, wobei das Mobilkommunikationsgerät (MG) mit einem Objektmodell (OM) verbunden ist, das die im Gebäude (B) befindlichen Geräte (Dev) repräsentiert,
(ST2) Bestimmen einer Route (R1 - R3) von der Position des Benutzers (P) bis zu dem Gerät (Dev), zu dem hin navigiert werden soll, auf der Grundlage von Informationen aus dem Objektmodell (OM) und/oder einem Gebäudenavigationssystem (IPS),
(ST3) Anzeigen der Route (R1 - R3) zu dem Gerät (Dev), zu dem hin navigiert werden soll, auf dem Display (D) des Mobilkommunikationsgeräts (MG),
(ST4) Nachverfolgen des Weiterkommens beim Laufen entlang der bestimmten Route (R1 - R3) durch Aufzeichnen von Messwerten aus Sensoren, die in das Mobilkommunikationsgerät (MG) integriert sind,
(ST5) Aufkurshalten und Synchronisieren des Benutzers (P) auf der bestimmten Route (R1 - R3) durch Einscannen von im Gebäude (B) angebrachten Ortungspunktcodes (QR) und/oder per Funk- und/oder Ton- und/oder Kameramittel des Mobilkommunikationsgeräts (MG),
(ST6) Synchronisieren eines Zeigers (AV1 - AV3), der den Benutzer (P) im Objektmodell (OM) repräsentiert, auf genau die gleiche Position im Objektmodell (OM), an der sich der Benutzer (P) derzeit im Gebäude (B) befindet,
(ST7) **dadurch gekennzeichnet, dass**, wenn der Benutzer (P) an dem Gerät (Dev) ankommt, zu dem hin navigiert werden soll, die durchschnittliche Schrittweite (ASD) des Benutzers (P), die Anzahl Schritte (NS), die der Benutzer (P) benötigt hat, um an dem Gerät (Dev) anzukommen, zu dem hin navigiert werden soll, und die Zeit (T), die der Benutzer benötigt hat, um an dem Gerät (Dev) anzukommen, zu dem hin navigiert werden soll, in einem geeigneten Navigationsdatenspeicher (NDM) gespeichert wird,
(ST8) wobei auf der Grundlage der in dem Navigationsdatenspeicher (NDM) gespeicherten Daten zukünftige Routen für das Navigieren eines Benutzers (P) zu einem Gerät (Dev) bestimmt werden, das sich in dem Gebäude (B) befindet.

2. Verfahren nach Anspruch 1, wobei das Anzeigen der Route (R1 - R3) das Darstellen des Zeigers (AV1 - AV3), insbesondere als Avatar (AV1 - AV3), auf der Route umfasst.

3. Verfahren nach Anspruch 1 oder Anspruch 2, wobei der Navigationsdatenspeicher Bestandteil des Objektmodells (OM) ist.

4. Verfahren nach einem der vorhergehenden Ansprüche, wobei es sich bei dem Objektmodell (OM) um ein Gebäudedatenmodell (BIM) oder ein 3D-Modell handelt.

5. Anordnung für das Navigieren eines Benutzers (P) zu einem Gerät (Dev), das sich in einem Gebäude (B) befindet, mit Folgendem:
einem Mobilkommunikationsgerät (MG), das so konfiguriert ist, dass es per Benutzereingabe das Gerät (Dev) auswählt, zu dem hin navigiert werden soll, wobei das Mobilkommunikationsgerät (MG) mit einem Objektmodell (OM) verbunden ist, das die im Gebäude (B) befindlichen Geräte (Dev) repräsentiert,
einem Server (S) mit Zugriff auf einen Speicher (DB), in dem das Objektmodell (OM) gespeichert ist, wobei der Server (S) so konfiguriert ist, dass er auf der Grundlage von Informationen aus dem Objektmodell (OM) eine Route (R1 - R3) von der Position des Benutzers (P) bis zu dem Gerät (Dev) bestimmt, zu dem hin navigiert werden soll,
wobei die Route (R1 - R3) zu dem Gerät (Dev), zu dem hin navigiert werden soll, auf dem Display (D) des Mobilkommunikationsgeräts (MG) angezeigt wird,
wobei das Mobilkommunikationsgerät (MG) so konfiguriert ist, dass es das Weiterkommen beim Laufen entlang der bestimmten Route (R1 - R3) durch Aufzeichnen von Messwerten aus Sensoren nachverfolgt, die in das Mobilkommunikationsgerät (MG) integriert sind,
wobei das Mobilkommunikationsgerät (MG) ferner so konfiguriert ist, dass es den Benutzer (P) durch Einscannen von im Gebäude (B) angebrachten Ortungspunktcodes (QR) und/oder per Funk- und/oder Ton- und/oder Kameramittel des Mobilkommunikationsgeräts (MG) auf der bestimmten Route (R1 - R3) auf Kurs hält und damit synchronisiert,
wobei der Server (S) so konfiguriert ist, dass er einen Zeiger (AV1 - AV3), der den Benutzer (P) im Objektmodell (OM) repräsentiert, auf genau die gleiche Position im Objektmodell (OM) synchronisiert, an der sich der Benutzer derzeit im Gebäude (B) befindet,
**dadurch gekennzeichnet, dass**,
wenn der Benutzer (P) an dem Gerät (Dev) ankommt, zu dem hin navigiert werden soll, die durchschnittliche Schrittweite (ASD) des Benutzers (P), die Anzahl Schritte, die der Benutzer (P) benötigt hat, um an dem Gerät (Dev) anzukommen, zu dem hin navigiert werden soll, und die Zeit (T), die der Benutzer benötigt hat, um an dem Gerät (Dev) anzukommen, zu dem hin navigiert werden soll, vom Server (S) oder vom Mobilkommunikationsgerät (MG) in einem geeigneten Navigationsdatenspeicher (NDM) gespeichert wird,
wobei der Server (S) ferner so konfiguriert ist, dass er auf der Grundlage der in dem Navigationsdatenspeicher (NDM) gespeicherten Daten zukünftige Routen (R1 - R3) für das Navigieren eines Benutzers (P) zu einem Gerät (Dev) bestimmt, das sich in dem Gebäude (B) befindet.

6. Anordnung nach Anspruch 5, wobei das Mobilkommunikationsgerät (MG) so konfiguriert ist, dass es den Zeiger (AV1 - AV3), insbesondere als Avatar (AV1 - AV3), auf der Route (R1 - R3) darstellt.

7. Anordnung nach Anspruch 5 oder Anspruch 6, wobei der Navigationsdatenspeicher (NDM) Bestandteil des Objektmodells (OM) ist.

8. Anordnung nach einem der vorhergehenden Ansprüche 5 bis 7, wobei es sich bei dem Objektmodell (OM) um ein Gebäudedatenmodell (BIM) oder ein 3D-Modell handelt.

9. Anordnung nach einem der vorhergehenden Ansprüche 5 bis 8, wobei der Server (S) Bestandteil einer Cloud-Infrastruktur (C) ist.

## Revendications

1. Procédé pour la navigation d'un utilisateur (P) jusqu'à un dispositif (Dev) situé dans un bâtiment (B), le procédé comprenant les étapes de :
(ST1) la fourniture d'un dispositif de communication mobile (MG) configuré pour sélectionner le dispositif (Dev) vers lequel naviguer par une saisie d'utilisateur, dans lequel le dispositif de communication mobile (MG) est connecté à un modèle objet (OM) représentant les dispositifs (Dev) situés dans le bâtiment (B) ;
(ST2) la détermination d'un itinéraire (R1 - R3) de la position de l'utilisateur (P) jusqu'au dispositif (Dev) vers lequel naviguer sur la base d'informations fournies par le modèle objet (OM) et/ou un système de positionnement en intérieur (IPS) ;
(ST3) l'affichage de l'itinéraire (R1 - R3) jusqu'au dispositif (Dev) vers lequel naviguer sur l'afficheur (D) du dispositif de communication mobile (MG) ;
(ST4) le suivi de la progression de la marche le long de l'itinéraire (R1 - R3) déterminé par l'enregistrement de valeurs mesurées de capteurs intégrés dans le dispositif de communication mobile (MG) ;
(ST5) le maintien de l'utilisateur (P) sur la bonne voie et synchronisé avec l'itinéraire (R1 - R3) déterminé par le balayage de codes de repère (QR) fixés dans le bâtiment (B) et/ou par des moyens radio et/ou audio et/ou d'appareil de prise de vues du dispositif de communication mobile (MG) ;
(ST6) la synchronisation d'un pointeur (AV1 - AV3) représentant l'utilisateur (P) au sein du modèle objet (OM) à la même exacte position dans le modèle objet (OM) que celle où l'utilisateur (P) se trouve actuellement dans le bâtiment (B) ;
(ST7) **caractérisé en ce que**, lorsque l'utilisateur (P) arrive au niveau du dispositif (Dev) vers lequel naviguer, la distance de pas moyen (ASD) de l'utilisateur (P), le nombre de pas (NS) dont l'utilisateur (P) avait besoin pour arriver au niveau du dispositif (Dev) vers lequel naviguer, et le temps (T) dont l'utilisateur avait besoin pour arriver au niveau du dispositif (Dev) vers lequel naviguer sont stockés dans une mémoire de données de navigation (NDM) appropriée ;
(ST8) dans lequel, sur la base des données stockées dans la mémoire de données de navigation (NDM), des itinéraires futurs pour la navigation d'un utilisateur (P) jusqu'à un dispositif (Dev) situé dans le bâtiment (B) sont déterminés.

2. Procédé selon la revendication 1, dans lequel l'affichage de l'itinéraire (R1 - R3) comprend l'illustration du pointeur (AV1 - AV3), notamment sous la forme d'un avatar (AV1 - AV3), sur l'itinéraire.

3. Procédé selon la revendication 1 ou la revendication 2, dans lequel la mémoire de données de navigation fait partie du modèle objet (OM).

4. Procédé selon l'une des revendications précédentes, dans lequel le modèle objet (OM) est un modèle d'informations de bâtiment (BIM) ou un modèle en 3D.

5. Agencement pour la navigation d'un utilisateur (P) jusqu'à un dispositif (Dev) situé dans un bâtiment (B), comprenant :
un dispositif de communication mobile (MG) configuré pour sélectionner le dispositif (Dev) vers lequel naviguer par une saisie d'utilisateur, dans lequel le dispositif de communication mobile (MG) est connecté à un modèle objet (OM) représentant les dispositifs (Dev) situés dans le bâtiment (B) ;
un serveur (S) comprenant l'accès à une mémoire (DB) où le modèle objet (OM) est stocké, dans lequel le serveur (S) est configuré pour déterminer un itinéraire (R1 - R3) de la position de l'utilisateur (P) jusqu'au dispositif (Dev) vers lequel naviguer sur la base d'informations fournies par le modèle objet (OM) ;
dans lequel l'itinéraire (R1 - R3) jusqu'au dispositif (Dev) vers lequel naviguer est affiché sur l'afficheur (D) du dispositif de communication mobile (MG) ;
dans lequel le dispositif de communication mobile (MG) est configuré pour suivre la progression de la marche le long de l'itinéraire (R1 - R3) déterminé par l'enregistrement de valeurs mesurées de capteurs intégrés dans le dispositif de communication mobile (MG) ;
dans lequel le dispositif de communication mobile (MG) est en outre configuré pour maintenir l'utilisateur (P) sur la bonne voie et synchronisé avec l'itinéraire (R1 - R3) déterminé par le balayage de codes de repère (QR) fixés dans le bâtiment (B) et/ou par des moyens radio et/ou audio et/ou d'appareil de prise de vues du dispositif de communication mobile (MG) ;
dans lequel le serveur (S) est configuré pour synchroniser un pointeur (AV1 - AV3) représentant l'utilisateur (P) au sein du modèle objet (OM) à la même exacte position dans le modèle objet (OM) que celle où l'utilisateur se trouve actuellement dans le bâtiment (B) ;
**caractérisé en ce que**, lorsque l'utilisateur (P) arrive au niveau du dispositif (Dev) vers lequel naviguer, la distance de pas moyen (ASD) de l'utilisateur (P), le nombre de pas dont l'utilisateur (P) avait besoin pour arriver au niveau du dispositif (Dev) vers lequel naviguer, et le temps (T) dont l'utilisateur avait besoin pour arriver au niveau du dispositif (Dev) vers lequel naviguer sont stockés par le serveur (S) ou par le dispositif de communication mobile (MG) dans une mémoire de données de navigation (NDM) appropriée ;
dans lequel le serveur (S) est en outre configuré, sur la base des données stockées dans la mémoire de données de navigation (NDM), pour déterminer des itinéraires futurs (R1 - R3) pour la navigation d'un utilisateur (P) jusqu'à un dispositif (Dev) situé dans le bâtiment (B).

6. Agencement selon la revendication 5, dans lequel le dispositif de communication mobile (MG) est configuré pour illustrer le pointeur (AV1 - AV3), notamment sous la forme d'un avatar (AV1 - AV3), sur l'itinéraire (R1 - R3).

7. Agencement selon la revendication 5 ou la revendication 6, dans lequel la mémoire de données de navigation (NDM) fait partie du modèle objet (OM).

8. Agencement selon l'une des revendications 5 à 7 précédentes, dans lequel le modèle objet (OM) est un modèle d'informations de bâtiment (BIM) ou un modèle en 3D.

9. Agencement selon l'une des revendications 5 à 8 précédentes, dans lequel le serveur (S) fait partie d'une infrastructure en nuage (C).
